(19) Europäisches Patentamt
European Patent Office
Office européen des brevets

(11) **EP 4 194 878 A1**

(12) **EUROPÄISCHE PATENTANMELDUNG**

(43) Veröffentlichungstag:
**14.06.2023  Patentblatt 2023/24**

(21) Anmeldenummer: **21213584.2**

(22) Anmeldetag: **10.12.2021**

(51) Internationale Patentklassifikation (IPC):
***G01R 33/565*** (2006.01)

(52) Gemeinsame Patentklassifikation (CPC):
**G01R 33/56518;** G01R 33/5607; G01R 33/56341

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(71) Anmelder: **Siemens Healthcare GmbH
91052 Erlangen (DE)**

(72) Erfinder:
• **Grodzki, David
91058 Erlangen (DE)**
• **Köhler, Michael
90408 Nürnberg (DE)**

(54) **VERFAHREN ZUR AUTOMATISCHEN KOMPENSATION VON WIRBELSTRÖMEN IN EINER MAGNETRESONANZVORRICHTUNG**

(57)     Die Erfindung betrifft ein Verfahren zur automatischen Kompensation von Wirbelströmen in einer Magnetresonanzvorrichtung (10), eine Kompensationsberechnungseinheit (26), eine Magnetresonanzvorrichtung (10) und ein Computerprogrammprodukt zur Ausführung des Verfahrens. Das Verfahren sieht vor: Ermitteln modifizierter Magnetresonanzsequenzdaten durch eine Kompensationsberechnungseinheit (26) als Zwischenschicht der Magnetresonanzvorrichtung (10), Durchführen einer Magnetresonanzmessung, bei der in der Magnetresonanzvorrichtung (10) Magnetfeldgradienten anhand der modifizierten Magnetresonanzsequenzdaten durch ein Gradientenerzeugungssystem (18, 19) erzeugt werden, wobei das Ermitteln der modifizierten Magnetresonanzsequenzdaten umfasst: Empfangen ursprünglicher Magnetresonanzsequenzdaten einer vorbestimmten Magnetresonanzsequenz, Berechnen einer Wirbelstrominformation über Wirbelströme, die durch Anwenden der ursprünglichen Magnetresonanzsequenzdaten in der Magnetresonanzvorrichtung (10) hervorgerufen werden würden, Berechnen zumindest eines Wirbelstromkompensationsgradientenpulses (Gecc) zur Kompensation der Wirbelströme anhand der berechneten Wirbelstrominformation, Erzeugen modifizierter Magnetresonanzsequenzdaten durch Einfügen des zumindest einen Wirbelstromkompensationsgradientenpulses (Gecc) in die ursprünglichen Magnetresonanzsequenzdaten und Ausgeben der modifizierten Magnetresonanzsequenzdaten an das Gradientenerzeugungssystem (18, 19) der Magnetresonanzvorrichtung (10).

FIG 1

EP 4 194 878 A1

**Beschreibung**

Die Erfindung betrifft ein Verfahren zur automatischen Kompensation von Wirbelströmen in einer Magnetresonanzvorrichtung, eine Kompensationsberechnungseinheit, eine Magnetresonanzvorrichtung und ein Computerprogrammprodukt zur Ausführung des Verfahrens.

In der Medizintechnik zeichnet sich die Bildgebung mittels Magnetresonanz (MR), auch Magnetresonanztomographie (MRT, engl. Magnetic Resonance Imaging, MRI) genannt, durch hohe Weichteilkontraste aus. Hierbei werden mit Hilfe einer Magnetresonanzvorrichtung Magnetresonanzsequenzen, insbesondere hochfrequente (HF, engl. radio-frequency, RF) Pulse zur Erzeugung eines HF-Feldes, in einen Untersuchungsbereich, in dem sich ein Patient befindet, eingestrahlt. Dadurch werden im Patienten ortskodierte Magnetresonanzsignale ausgelöst. Die Magnetresonanzsignale werden als Messdaten von der Magnetresonanzvorrichtung empfangen und zur Rekonstruktion von Magnetresonanzabbildungen verwendet.

Zur Ortskodierung der Magnetresonanzsignale wird üblicherweise ein homogenes Hauptmagnetfeld mit einem - meist linearen - Magnetfeldgradienten (oftmals auch "Gradientenfeld" oder kurz "Gradient" genannt) überlagert, sodass an das resultierende Gesamtmagnetfeld bzw. die damit verknüpfte Lamorfrequenz räumlich variiert.

In einem optimalen Fall hat das Gradientenfeld zum einen nur Komponenten entlang des Hauptmagnetfeldes (z.B. in z-Richtung) und lässt sich zum anderen exakt zeitlich aussteuern. Üblicherweise lässt sich jedoch dieser optimale Fall in der Praxis aufgrund von Maxwell-Thermen, also Komponenten des Gradientenfelds in x- und/oder y-Richtung, und Wirbelströmen nicht erreichen. Wirbelströme werden durch zeitlich verändernde Magnetfelder erzeugt, insbesondere durch Rampen von Gradientenpulsen. Zur Vermeidung von Wirbelströmen werden beispielsweise längere effektive Repetitionszeiten gewählt, so dass in den "Pausen" vor der nächsten Repetition Wirbelströme abklingen können. Dies kann jedoch zu längeren Messzeiten führen und bedarf unter Umständen eine spezifische Anpassung der Magnetresonanzsequenz.

Als Aufgabe der vorliegenden Erfindung kann angesehen werden, ein Verfahren für eine unaufwändige, insbesondere sequenzunabhängige, Vermeidung von Wirbelstromartefakten bei bildgebenden Magnetresonanzmessungen anzugeben.

Die Aufgabe wird durch die Merkmale der unabhängigen Ansprüche gelöst. Vorteilhafte Ausgestaltungen sind in den abhängigen Ansprüchen beschrieben.

Demnach wird ein, insbesondere computer-implementiertes, Verfahren zur automatischen Kompensation von Wirbelströmen in einer Magnetresonanzvorrichtung vorgeschlagen. Dabei werden modifizierte Magnetresonanzsequenzdaten durch eine Kompensationsberechnungseinheit der Magnetresonanzvorrichtung ermittelt. Dabei ist die Kompensationsberechnungseinheit eine Zwischenschicht der Magnetresonanzvorrichtung. Ferner wird eine Magnetresonanzmessung durchgeführt. Dabei erzeugt ein Gradientenerzeugungssystem der Magnetresonanzvorrichtung anhand der modifizierten Magnetresonanzsequenzdaten Magnetfeldgradienten, insbesondere Wirbelstromkompensationsgradientenpulse, in der Magnetresonanzvorrichtung.

Die modifizierten Magnetresonanzsequenzdaten werden folgendermaßen ermittelt: Die Kompensationsberechnungseinheit empfängt, z.B. von einer Systemsteuereinheit, ursprüngliche Magnetresonanzsequenzdaten einer vorbestimmten Magnetresonanzsequenz. Die Kompensationsberechnungseinheit berechnet eine Wirbelstrominformation über (ursprüngliche) Wirbelströme, welche Wirbelströme durch Anwenden der ursprünglichen Magnetresonanzsequenzdaten in der Magnetresonanzvorrichtung hervorgerufen werden würden, falls keine Gegenmaßnahmen vorgenommen werden. Die Wirbelstrominformation kann insbesondere die Stärke und/oder die Form und/oder die Dauer und/oder den Verlauf und/oder eine andere Eigenschaft umfassen, die die (zu kompensierenden) Wirbelströme charakterisiert. Ferner berechnet die Kompensationsberechnungseinheit anhand dieser Wirbelstrominformation zumindest einen Wirbelstromkompensationsgradientenpuls zur Kompensation der (zu kompensierenden) Wirbelströme. Die Kompensationsberechnungseinheit erzeugt modifizierte Magnetresonanzsequenzdaten, indem der zumindest eine Wirbelstromkompensationsgradient in die ursprünglichen Magnetresonanzsequenzdaten eingefügt wird. Schließlich gibt die Kompensationsberechnungseinheit die modifizierten Magnetresonanzsequenzdaten an das Gradientenerzeugungssystems, insbesondere an eine Gradientensteuereinheit des Gradientenerzeugungssystems, der Magnetresonanzvorrichtung aus.

Indem die Kompensationsberechnungseinheit als Zwischenschicht, insbesondere zwischen einer Systemsteuereinheit und dem Gradientenerzeugungssystem, fungiert, kann eine einfache und automatisierte Wirbelstromkompensation erreicht werden. Vorteilhafterweise kann dies unabhängig von der Art und/oder Klasse der vorbestimmten Magnetresonanzsequenz erfolgen. Die Zwischenschicht kann dabei als Software und/oder als Hardware ausgebildet sein. Die Zwischenschicht kann insbesondere als "Blackbox" fungieren.

Die Magnetresonanzsequenzdaten umfassen beispielsweise Steuerbefehle zum Applizieren einer Abfolge Sequenzmodulen, wie z.B. Gradientenpulse (zur Erzeugung von Magnetfeldgradienten) und/oder HF-Pulse, durch die Magnetresonanzvorrichtung. Dabei kann ein Magnetfeldgradient beispielsweise von einer oder mehreren Gradientenspulen einer Gradientenspuleneinheit des Gradientenerzeugungssystems erzeugt werden. Ein HF-Puls kann beispielsweise von einer oder

mehreren Sendespulen einer Hochfrequenzantenneneinheit erzeugt werden. Die Magnetresonanzsequenzdaten können insbesondere ein Teil eines Messprotokolls sein.

Die Kompensationsberechnungseinheit umfasst vorzugsweise einen oder mehrere Prozessoren, um die Berechnungen durchführen zu können. Die Kompensationsberechnungseinheit umfasst vorzugsweise eine oder mehrere Schnittstellen, um die ursprünglichen Magnetresonanzsequenzdaten empfangen und/oder die modifizierten Magnetresonanzsequenzdaten ausgeben zu können.

Das Berechnen der Wirbelströme umfasst insbesondere ein Berechnen, insbesondere zeitlich, (auf)akkumulierter Wirbelströme während eines Durchlaufens der vorbestimmten Magnetresonanzsequenz.

Vorzugsweise wird, insbesondere allein, unter Verwendung von Abklingkonstanten bzw. Zeitkonstanten, die Stärke der Wirbelströme berechnet; diese Berechnung erfolgt vorzugsweise unabhängig vom örtlichen Verlauf der Wirbelströme.

Wirbelströme werden üblicherweise durch zeitlich ändernde Magnetfelder erzeugt, insbesondere durch Rampen von Gradientenpulsen. Nach der Rampe eines Gradientenpulses kann (vereinfachend) von einem exponentiellen Abklingen des dadurch erzeugten Magnetfeldes ausgegangen werden:

$$B_{EC}(t) = G \, A \, \exp(-t/\tau)$$

Dabei bezeichnet $B_{EC}(t)$ das durch den Wirbelstrom (engl. eddy current) erzeugte Magnetfeld, $G$ die Gradientenamplitude nach Beendigung der Rampe, $A$ eine Proportionalitätskonstante, $t$ die Zeit und $\tau$ eine Abklingkonstante dieses Wirbelstromes. (Für die Gleichung wurde angenommen, dass die Abklingkonstante lang verglichen mit der Rampendauer des erzeugenden Gradienten ist, so dass die Amplitude des Wirbelstroms am Ende der Rampe proportional zu der Gradientenamplitude ist.)

Vorzugsweise umfasst das Ermitteln der modifizierten Magnetresonanzsequenzdaten durch die Kompensationsberechnungseinheit eine Auswertung der Gradientenverläufe der ursprünglicher Magnetresonanzsequenzdaten. Vorzugsweise werden wirbelstrominduzierte Feldstörungen mittels Modellierung und/oder einer Filterfunktionen berechnet.

Vorzugsweise erfolgt das Berechnen der Wirbelströme anhand zumindest eines Parameters, der spezifisch für einen Typ der Magnetresonanzvorrichtung ist. Beispielsweise kann die Filterfunktion spezifisch für die Magnetresonanzvorrichtung sein, insbesondere für den Typ der Magnetresonanzvorrichtung. Die Filterfunktion kann insbesondere zumindest eine Abklingkonstante $\tau$ umfassen. Als Grundlage dafür kann insbesondere der vorab beschriebene exponentielle Abfall des durch eine Gradientenrampe erzeugten Wirbelstromes dienen.

Am Ende werden die Wirbelströme ja durch das Ausspielen eines Gradienten, der ja wiederum Wirbelström erzeugt, kompensiert. Dieser Gradient muss also Wirbelströme der umgekehrten Polarität erzeugen, um diese "aufakkumulierten" Wirbelströme zu kompensieren. Dadurch, dass dieser Kompensationsgradient wieder die gleiche räumliche Verteilung von Wirbelströmen erzeugt wie die vorhergehenden Gradienten der Sequenz, ist eine Berechnung der räumlichen Verteilung nicht nötig.

Vorzugsweise werden bei der Magnetresonanzmessung Magnetresonanzsignale erzeugt, die von der Magnetresonanzvorrichtung empfangen und ausgewertet werden. Typischerweise werden dabei aus den Magnetresonanzsignalen eine oder mehrere Magnetresonanzabbildungen rekonstruiert. Durch das Applizieren der Magnetfeldgradienten durch Gradientenpulse werden den Magnetresonanzsignalen vorteilhafterweise Ortsinformationen aufgeprägt.

Der zumindest eine Wirbelstromkompensationsgradientenpuls ist vorzugsweise ausgebildet zur Erzeugung von Kompensationswirbelströmen, die geeignet sind, die wirbelstrom-induzierten Feldstörungen, die ansonsten durch die zu kompensierenden Wirbelströme ohne Modifikation der Magnetresonanzsequenzdaten auftreten würden, zum Teil oder gänzlich auszugleichen. Vorzugsweise weist der zumindest eine Wirbelstromkompensationsgradientenpuls eine entgegengesetzte Polarität auf gegenüber der über einen gewissen Zeitraum gemittelten Amplitude vorangegangener Magnetfeldgradienten gemäß den ursprünglichen Magnetresonanzsequenzdaten. Gerade bei geringen Feldstärken des Hauptmagnetfeldes, in denen Einflüsse von Wirbelströmen aufgrund der geringen absoluten Frequenzdifferenz zwischen Fett und Wasser besonders groß sind, ist eine Wirbelstromkompensation besonders vorteilhaft.

Die ursprünglichen Magnetresonanzsequenzdaten sind insbesondere Daten, die keine etwaigen Wirbelstromeffekte bei der Magnetresonanzmessung berücksichtigen. Vorteilhafterweise repräsentieren die ursprünglichen Magnetresonanzsequenzdaten beliebige Magnetresonanzsequenzen. Vorteilhafterweise muss bei der Erstellung der ursprünglichen Magnetresonanzsequenzdaten auf etwaig auftretende Wirbelströme keine Rücksicht genommen werden.

Das vorgeschlagene Verfahren zur automatischen Kompensation von Wirbelströmen ist insbesondere dann vorteilhaft, wenn sich in verschiedenen Teilen der vorbestimmten Magnetresonanzsequenz das Gradientenschema, insbesondere die Abfolge der Magnetfeldgradienten, ändert. Eine fixe einmalige Vorabberechnung etwaiger Wirbelstromkompensationsgradientenpulse ist dann aufwendig und/oder fehleranfällig. Aber durch die vorgeschlagene dynamische und automatische Ermittlung der modifizierten Magnetresonanzsequenzdaten können die ursprünglichen Magnetresonanzsequenzdaten flexibel angepasst werden.

Vorzugsweise werden die modifizierten Magnetresonanzsequenzdaten zumindest teilweise während der Magnetresonanzmessung ermittelt. Insbesondere erfolgt das Ermitteln der modifizierten Magnetresonanzsequenzdaten in Echtzeit und/oder on-the-fly erfolgt. Mit "on-the-fly" kann insbesondere gemeint sein, dass auf ein dauerhaftes oder temporäres Speichern von Daten, insbesondere der modifizierten Magnetresonanzsequenzdaten, verzichtet wird.

Insbesondere erfolgt das Ermitteln der modifizierten Magnetresonanzsequenzdaten wiederholt und/oder laufend während dem Durchführen der Magnetresonanzmessung. Das Ermitteln der modifizierten Magnetresonanzsequenzdaten erfolgt also nicht nur einmal, z.B. zu Beginn oder vor der Magnetresonanzmessung. Insbesondere werden immer wieder andere, insbesondere in der vorbestimmten Magnetresonanzsequenz aufeinander folgende, ursprüngliche Magnetresonanzsequenzdaten der Kompensationsberechnungseinheit zum Ermitteln weiterer modifizierter Magnetresonanzsequenzdaten bereitgestellt. Beispielsweise wird die vorbestimmte Magnetresonanzsequenz in verschiedene Sequenzabschnitte aufgeteilt, wobei jeder Sequenzabschnitt jeweils ursprüngliche Magnetresonanzsequenzdaten aufweist und diese ursprüngliche Magnetresonanzsequenzdaten während Magnetresonanzmessung laufend durch das Ermitteln der modifizierten Magnetresonanzsequenzdaten modifiziert und als modifizierte Magnetresonanzsequenzdaten an das Gradientenerzeugungssystem der Magnetresonanzvorrichtung ausgegeben werden.

Vorteilhafterweise kann das Verfahren zur automatischen Kompensation von Wirbelströmen auf jeden Sequenztyp angewendet werden; der Verfahrensablauf muss vorteilhafterweise nicht von Sequenztyp zu Sequenztyp angepasst werden. Insbesondere ist keine sequenz-spezifische Implementierung einer Wirbelstromkorrektur notwendig, sondern es findet eine generalisierte, sequenzunabhängige Berechnung statt.

Eine weitere Ausführungsform des Verfahrens sieht vor, dass die ursprünglichen Magnetresonanzsequenzdaten der vorbestimmten Magnetresonanzsequenz aus einer Systemsteuereinheit der Magnetresonanzvorrichtung bereitgestellt werden. Vorzugsweise bleiben dabei die ursprünglichen Magnetresonanzsequenzdaten der vorbestimmten Magnetresonanzsequenz in der Steuereinheit unverändert. Das Bereitstellen der ursprünglichen Magnetresonanzsequenzdaten kann beispielsweise durch ein Einstellen einer beliebigen vorbestimmten Magnetresonanzsequenz und einem Starten der Magnetresonanzmessung, z.B. durch ein Bedienpersonal der Magnetresonanzvorrichtung, ausgelöst werden.

Dabei ist die Systemsteuereinheit insbesondere eine der Zwischenschicht vorgeschaltete Einheit in einem Signalweg zum Gradientenerzeugungssystem. Vorzugsweise wird die Zwischenschicht in den Signalweg eingefügt. Dies kann vorzugsweise durch eine Verwendung von, insbesondere logischen, Verbindungen zwischen Komponenten der Magnetresonanzvorrichtung erfolgen. Die Zwischenschicht kann Software und/oder Hardware umfassen. Eine solche Software ist kann insbesondere Programmieranweisungen enthalten, um es der Zwischenschicht zu ermöglichen, die ursprünglichen Magnetresonanzsequenzdaten zu erfassen, zu sammeln, zu senden und/oder zu empfangen, z.B. von einer Systemsteuereinheit der Magnetresonanzvorrichtung und/oder von einem Speicher und/oder von einem Analog-Digital-Wandler und/oder von einer anderen Software der Magnetresonanzvorrichtung.

Die ursprünglichen Magnetresonanzsequenzdaten können insbesondere Bilderfassungsparameter, Bilderfassungsbefehle und/oder Steuerbefehle zum Steuern der Magnetresonanzvorrichtung umfassen. Das Ermitteln der modifizierten Magnetresonanzsequenzdaten kann insbesondere in Echtzeit durch die Kompensationsberechnungseinheit erfolgen. Vorzugsweise bleiben die ursprünglichen Magnetresonanzsequenzdaten an sich unverändert, d.h. es werden zwar modifizierte Magnetresonanzsequenzdaten ermittelt und ausgegeben, aber dies bleibt ohne Auswirkung auf die ursprünglichen Magnetresonanzsequenzdaten im vorgeschalteten Signalweg.

Bevorzugt umfasst die vorbestimmte Magnetresonanzsequenz eine diffusionsgewichtete Sequenz (engl. diffusion-weighted imaging sequence, DWI sequence).

Während z.B. Turbo-Spin-Echo-basierte Sequenzen üblicherweise eine vergleichsweise einfache, repetitive Struktur aufweisen, so dass hier die Wirbelstromkompensationsgradientenpulse auch einmalig für eine Messung berechnet werden könnten und nicht in jeder Repetition angepasst werden müssten, werden die Wirbelströme bei DWI-Sequenzen durch die sich in jeder Repetition ändernden Diffusionsgradienten dominiert. Daher ist die hier vorgeschlagene flexible Kompensation von Wirbelströmen besonders vorteilhaft.

Eine weitere Ausführungsform des vorgeschlagenen Verfahrens sieht vor, dass das Ermitteln der modifizierten Magnetresonanzsequenzdaten ein Erkennen zumindest eines Fettsättigungspulses in den ursprünglichen Magnetresonanzsequenzdaten umfasst, wobei vor dem zumindest einen Fettsättigungspuls ein Wirbelstromkompensationsgradient in die ursprünglichen Magnetresonanzsequenzdaten eingefügt wird. Üblicherweise werden Fettsättigungspulse zu Beginn einer Repetition der Magnetresonanzsequenz ausgesendet. Vorteilhafterweise wird der Wirbelstromkompensationsgradient am Ende der vorangehenden Repetition eingefügt.

Bei dem Erkennen zumindest eines Fettsättigungspulses kann man sich zu Nutze machen, dass HF-Pulse zur chemischen Fettsättigung üblicherweise offresonant sind, das heißt, sie weisen eine andere Frequenz auf als die (meisten) anderen HF-Pulse der vorbestimmten Magnetresonanzsequenz. Diese geänderte Frequenz wird deshalb appliziert, um selektiv die Fett-Protonen anzuregen bzw. zu sättigen, die eine andere Resonanzfrequenz aufweisen als Wasser-Protonen.

Insbesondere Wirbelströme mit Zeitkonstanten > 10 ms können bei typischen Magnetresonanzsequenzen durch die durch sie induzierten Feldstörungen vor allem die spektrale Fettsättigung stören. Daher ist eine Kompensation von Wirbelströmen hier besonders wirksam.

Vorzugsweise sieht die vorbestimmte Magnetresonanzsequenz ein Anwenden von Gradientenpulsen auf mehreren Achsen des Gradientenerzeugungssystems, insbesondere der Gradientenspuleneinheit, vor, wobei bei dem Berechnen des zumindest eines Wirbelstromkompensationsgradientenpulses alle bisher in der Magnetresonanzmessung angewandten Gradientenpulse auf den mehreren Achsen des Gradientenerzeugungssystems der Magnetresonanzvorrichtung berücksichtigt werden.

Vorzugsweise werden alle in der Magnetresonanzmessung bislang auf den einzelnen Achsen durchlaufenen Gradiententrajektorien berücksichtigt. Vorteilhafterweise ist es für den Algorithmus zum Ermitteln der modifizierten Magnetresonanzsequenzdaten irrelevant in welcher Repetition oder nach welchem DWI-Block er sich befindet, da all diese Gradientenpulse vorher in der Berechnung erfasst worden waren. Der zumindest eine Wirbelstromkompensationsgradientenpuls wird dabei bevorzugt so ausgelegt, dass die durch ihn erzeugten Wirbelströme die bereits vorhandenen wirbelstrom-induzierten Feldstörungen ganz oder teilweise kompensieren.

Eine weitere Ausführungsform des vorgeschlagenen Verfahrens sieht vor, dass das Ermitteln der modifizierten Magnetresonanzsequenzdaten ein Abschätzen einer Magnetfeldstörung umfasst, welche durch die Wirbelströme bei Anwenden der ursprünglichen Magnetresonanzsequenzdaten in der Magnetresonanzvorrichtung hervorgerufen werden würde, wobei nur dann ein Wirbelstromkompensationsgradientenpuls berechnet und in die ursprünglichen Magnetresonanzsequenzdaten eingefügt wird, wenn die Magnetfeldstörung einen vorgegebenen Schwellwert überschreitet.

Beispielsweise kann applikationsabhängig spezifiziert werden, bis zu welchem Teil (z.B. 50% oder bis zu einer gewissen definierten tolerierbaren Feldstörung) die vorhandenen Feldstörungen kompensiert werden. Das kann insbesondere die notwendige Dauer und/oder die benötigte Amplitude des Wirbelstromkompensationsgradientenpulses reduzieren.

Eine weitere Ausführungsform des vorgeschlagenen Verfahrens sieht vor, dass das Ermitteln der modifizierten Magnetresonanzsequenzdaten eine Identifizierung eines Zeitabschnitts in den ursprünglichen Magnetresonanzsequenzdaten umfasst, in dem durch die Magnetresonanzvorrichtung keine Gradientenpulse geschaltet oder HF-Pulse gesendet werden, wobei der zumindest eine Wirbelstromkompensationsgradientenpuls in den identifizierten Zeitabschnitt in die ursprünglichen Magnetresonanzsequenzdaten eingefügt wird. Vorteilhafterweise kann dadurch erreicht werden, dass das Timing der Magnetresonanzsequenz nicht verändert werden muss.

Bevorzugt weisen die ursprünglichen Magnetresonanzsequenzdaten zumindest einen dedizierten Platzhalter zum Einfügen berechneter Wirbelstromkompensationsgradientenpulse auf. Auch auf diese Weise könnte erreicht werden, dass das Timing der Magnetresonanzsequenz nicht verändert werden muss. Die Platzhalter können beispielsweise durch ein Kennzeichen (engl. flag) als solche gekennzeichnet werden, womit direkt auch die vorteilhafte Stelle vorgegeben wäre. Eine möglicherweise aufwändigere Identifizierung von Pausen könnte so entfallen.

Ferner wird eine Kompensationsberechnungseinheit zum Ermitteln von modifizierten Magnetresonanzsequenzdaten einer Magnetresonanzmessung durch eine Magnetresonanzvorrichtung vorgeschlagen. Ferner wird eine Magnetresonanzvorrichtung mit einer Kompensationsberechnungseinheit als Zwischenschicht vorgeschlagen. Dabei ist die Kompensationsberechnungseinheit bzw. die Magnetresonanzvorrichtung ausgebildet, ein vorab beschriebenes Verfahren auszuführen. Die Vorteile der Kompensationsberechnungseinheit bzw. der Magnetresonanzvorrichtung entsprechen im Wesentlichen den Vorteilen des dargestellten Verfahrens zur automatischen Kompensation von Wirbelströmen in einer Magnetresonanzvorrichtung, welche vorab im Detail ausgeführt sind.

Ferner wird ein Computerprogrammprodukt vorgeschlagen, das ein Programm umfasst und direkt in einen Speicher einer programmierbaren Kompensationsberechnungseinheit einer Magnetresonanzvorrichtung ladbar ist und Programmmittel, z.B. Bibliotheken und Hilfsfunktionen, aufweist, um modifizierte Magnetresonanzsequenzdaten zu ermitteln, wenn das Computerprogrammprodukt in der Kompensationsberechnungseinheit der Magnetresonanzvorrichtung ausgeführt wird. Das Computerprogrammprodukt kann dabei eine Software mit einen Quellcode, der noch kompiliert und gebunden oder der nur interpretiert werden muss, oder einen ausführbaren Softwarecode umfassen, der zur Ausführung nur noch in die Kompensationsberechnungseinheit zu laden ist. Mit Hilfe das Computerprogrammprodukt kann das erfindungsgemäße Verfahren schnell, identisch wiederholbar und robust ausgeführt werden.

Das Computerprogrammprodukt ist so konfiguriert, dass mit seiner Hilfe die erfindungsgemäßen Verfahrensschritte ausführen werden können. Die Kompensationsberechnungseinheit muss dabei jeweils die Voraussetzungen wie beispielsweise einen entsprechenden Arbeitsspeicher, eine entsprechende Grafikkarte oder eine entsprechende Logikeinheit aufweisen, so dass die jeweiligen Verfahrensschritte effizient ausgeführt werden können. Das Computerprogrammprodukt ist beispielsweise auf einem computerlesbaren Medium gespeichert oder auf einem Netzwerk oder Server hinterlegt, von wo es in den Prozessor einer lokalen Kompensationsberechnungseinheit geladen werden kann, der mit der Magnetresonanzvorrichtung direkt verbunden oder als Teil der Magnetresonanzvorrichtung ausgebildet sein kann.

Weiterhin können Steuerinformationen des Computerprogrammprodukts auf einem elektronisch lesbaren Datenträger gespeichert sein. Die Steuerinformationen des elektronisch lesbaren Datenträgers können derart ausgestaltet sein, dass sie bei Verwendung des Datenträgers in einer Kompensationsberechnungseinheit einer Magnetresonanzvorrichtung ein erfindungsgemäßes Verfahren durchführen. Beispiele für elektronische lesbare Datenträger sind eine DVD, ein Magnetband oder einen USB-Stick, auf welchem elektronisch lesbare Steuerinformationen, insbesondere Software, gespeichert ist. Wenn diese Steuerinformationen von dem Datenträger gelesen und in eine Kompensationsberechnungseinheit der Magnetresonanzvorrichtung gespeichert werden, können alle erfindungsgemäßen Ausführungsformen der vorab beschriebenen Verfahren durchgeführt werden. So kann die Erfindung auch von dem besagten computerlesbaren Medium und/oder dem besagten elektronisch lesbaren Datenträger ausgehen.

Weitere Vorteile, Merkmale und Einzelheiten der Erfindung ergeben sich aus den im Folgenden beschriebenen Ausführungsbeispielen sowie anhand der Zeichnungen. Einander entsprechende Teile sind in allen Figuren mit den gleichen Bezugszeichen versehen.

Es zeigen:

Fig. 1 eine Magnetresonanzvorrichtung in einer schematischen Darstellung,

Fig. 2 eine Ablaufdiagramm eines vorgeschlagenen Verfahrens,

Fig. 3 eine Sequenzdiagramm mit einem eingefügten Wirbelstromkompensationsgradientenpuls.

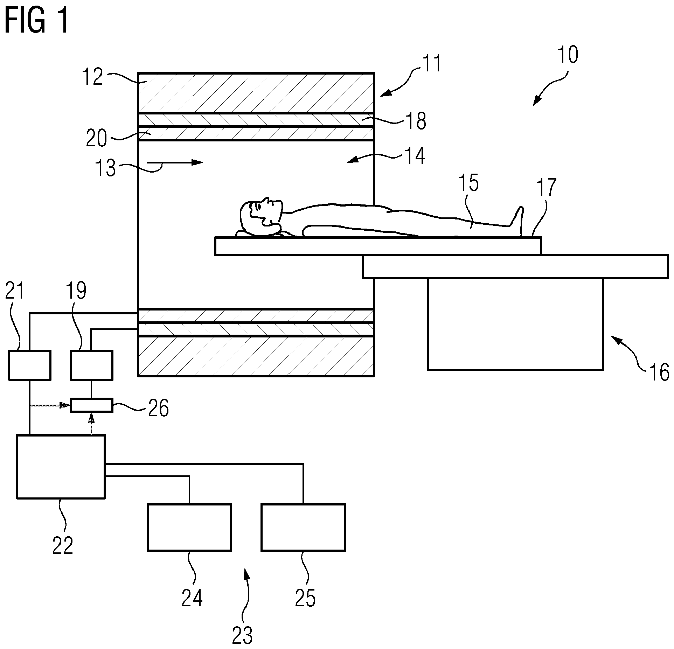

In Fig. 1 ist eine Magnetresonanzvorrichtung 10 schematisch dargestellt. Die Magnetresonanzvorrichtung 10 umfasst eine Magneteinheit 11, die einen Hauptmagneten 12 zu einem Erzeugen eines starken und insbesondere zeitlich konstanten Hauptmagnetfelds 13 aufweist. Zudem umfasst die Magnetresonanzvorrichtung 10 einen Patientenaufnahmebereich 14 zu einer Aufnahme eines Patienten 15. Der Patientenaufnahmebereich 14 im vorliegenden Ausführungsbeispiel ist zylinderförmig ausgebildet und in einer Umfangsrichtung von der Magneteinheit 11 zylinderförmig umgeben. Grundsätzlich ist jedoch eine davon abweichende Ausbildung des Patientenaufnahmebereichs 14 jederzeit denkbar. Der Patient 15 kann mittels einer Patientenlagerungsvorrichtung 16 der Magnetresonanzvorrichtung 10 in den Patientenaufnahmebereich 14 geschoben werden. Die Patientenlagerungsvorrichtung 16 weist hierzu einen innerhalb des Patientenaufnahmebereichs 14 bewegbar ausgestalteten Patiententisch 17 auf.

Die Magneteinheit 11 weist weiterhin eine Gradientenspuleneinheit 18 zu einer Erzeugung von Magnetfeldgradienten auf, die für eine Ortskodierung während einer Bildgebung verwendet werden. Die Gradientenspuleneinheit 18 wird mittels einer Gradientensteuereinheit 19 der Magnetresonanzvorrichtung 10 gesteuert. Die Gradientenspuleneinheit 18 und die Gradientensteuereinheit 19 sind Teile eines Gradientenerzeugungssystems. Die Magneteinheit 11 umfasst weiterhin eine Hochfrequenzantenneneinheit 20, welche im vorliegenden Ausführungsbeispiel als fest in die Magnetresonanzvorrichtung 10 integrierte Körperspule ausgebildet ist. Die Hochfrequenzantenneneinheit 20 wird von einer Hochfrequenzantennensteuereinheit 21 der Magnetresonanzvorrichtung 10 gesteuert und strahlt Magnetresonanzsequenzen in einen Untersuchungsraum ein, der im Wesentlichen von einem Patientenaufnahmebereich 14 der Magnetresonanzvorrichtung 10 gebildet ist. Dadurch stellt sich dem von dem Hauptmagneten 12 erzeugten Hauptmagnetfeld 13 eine Anregung von Atomkernen ein. Durch Relaxation der angeregten Atomkerne werden Magnetresonanzsignale erzeugt. Die Hochfrequenzantenneneinheit 20 ist zum Empfang der Magnetresonanzsignale ausgebildet. Die Die Hochfrequenzantenneneinheit 20 und die Hochfrequenzantennensteuereinheit 21 sind Teile eines Hochfrequenzerzeugungssystems.

Zu einer Steuerung des Hauptmagneten 12, der Gradientensteuereinheit 19 und zur Steuerung der Hochfrequenzantennensteuereinheit 21 weist die Magnetresonanzvorrichtung 10 eine Systemsteuereinheit 22 auf. Die Systemsteuereinheit 22 steuert zentral die Magnetresonanzvorrichtung 10, wie insbesondere das Durchführen einer vorbestimmten Magnetresonanzsequenz, beispielsweise einer Gradientenechosequenz. Zudem umfasst die Systemsteuereinheit 22 eine nicht näher dargestellte Auswerteeinheit zu einer Auswertung der Magnetresonanzsignale, die während der Magnetresonanzuntersuchung erfasst werden. Des Weiteren umfasst die Magnetresonanzvorrichtung 10 eine Benutzerschnittstelle 23, die mit der Systemsteuereinheit 22 verbunden ist. Steuerinformationen wie beispielsweise Bildgebungsparameter, sowie rekonstruierte Magnetresonanzabbildungen können auf einer Anzeigeeinheit 24, beispielsweise auf zumindest einem Monitor, der Benutzerschnittstelle 23 für ein medizinisches Bedienpersonal angezeigt werden. Weiterhin weist die Benutzerschnittstelle 23 eine Eingabeeinheit 25 auf, mittels der Informationen und/oder Parameter während eines Messvorgangs von dem medizinischen Bedienpersonal eingegeben werden können.

Zwischen der Systemsteuereinheit 22 und der Gradientensteuereinheit 19 ist als Zwischenschicht eine Kompensationsberechnungseinheit 26 zur automatischen Kompensation von Wirbelströmen angeordnet. Die Kompensationsberechnungseinheit 26 kann sowohl Hardware- als auch Software-Bestandteile umfassen. Vorzugsweise werden etwaige Daten, insbesondere Magnetresonanzsequenzdaten einer vorbestimmten Magnetresonanzsequenz, aus der Systemsteuereinheit 22 der Magnetresonanzvorrichtung 10 an die Kompensationsberechnungseinheit 26 bereitgestellt werden, ohne dass diese Daten in der Steuereinheit 22 irgendwie verändert werden.

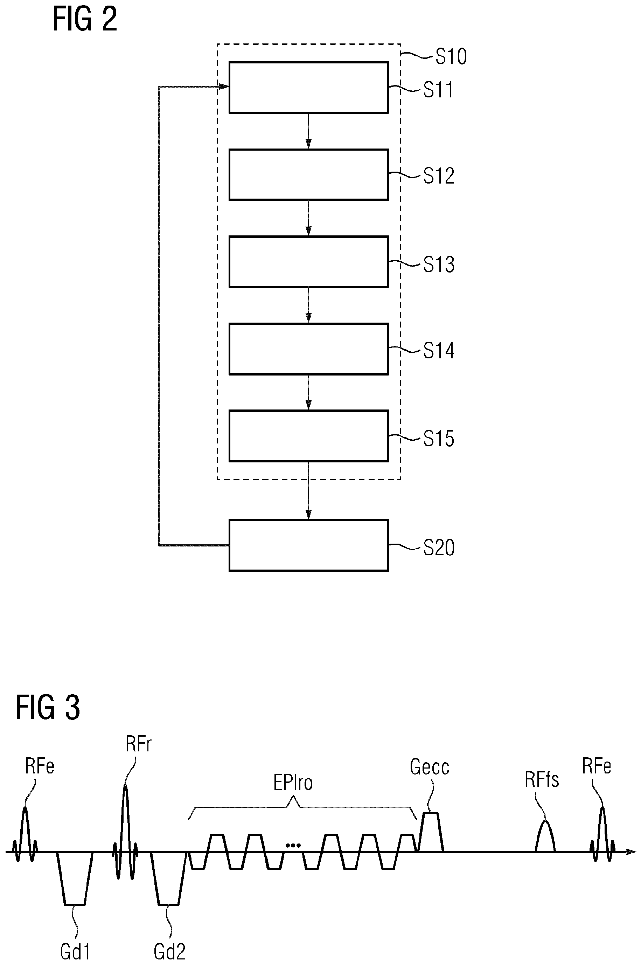

Die Kompensationsberechnungseinheit 26 ist modular in die Magnetresonanzvorrichtung 10 integriert. Die Kompensationsberechnungseinheit 26 ist vorzugsweise so ausgebildet, dass bei Entfernung der Kompensationsberechnungseinheit 26 aus der Magnetresonanzvorrichtung 10 das Gradientenerzeugungssystem mit Ausnahme der dann fehlenden Wirbelstromkorrektur ohne weitere Einschränkungen weiter betrieben werden könnte. Ein entsprechendes Verfahren zur automatischen Kompensation von Wirbelströmen in der Magnetresonanzvorrichtung 10 ist in Fig. 2 dargestellt: In S10 werden durch die Kompensationsberechnungseinheit 26 modifizierte Magnetresonanzsequenzdaten ermittelt.

S10 umfasst dazu mehrere Schritte: In S11 werden von der Systemsteuereinheit 22 ursprüngliche Magnetresonanzsequenzdaten einer vorbestimmten Magnetresonanzsequenz empfangen. Diese Magnetresonanzsequenz kann verschiedene Sequenzmodule umfassen. Die Sequenzmodule können insbesondere HF-Pulse, die mittels des Hochfrequenzerzeugungssystems ausgegeben werden, und/oder Gradientenpulse, die mittels des Gradientenerzeugungssystems ausgegeben werden, umfassen. Die Systemsteuereinheit 22 und/oder die Kompensationsberechnungseinheit 26 weisen zur Übermittlung der Magnetresonanzsequenzdaten geeignete Schnittstellen auf.

In S12 wird in der Kompensationsberechnungseinheit 26 eine Wirbelstrominformation über Wirbelströme berechnet, die durch Anwenden der ursprünglichen Magnetresonanzsequenzdaten in der Magnetresonanzvorrichtung hervorgerufen werden würden.

Insbesondere werden die aufakkumulierten Wirbelströme während des Durchlaufens der vorbestimmten Magnetresonanzsequenz, also während der Magnetresonanzmessung, berechnet und/oder getrackt. Dazu werden beispielsweise die Gradientenverläufe der empfangenen ursprünglichen Magnetresonanzsequenzdaten ausgewertet und mittels Modellierung und der für den Typ der Magnetresonanzvorrichtung 10 bekannten Filterfunktionen (z.B. Abklingkonstanten von Wirbelströmen) die wirbelstrominduzierten Feldstörungen mit berechnet. Als Grundlage dafür kann ein exponentieller Abfall des durch eine Gradientenrampe erzeugten Wirbelstromes dienen, wie er vorab bereits beschrieben wurde.

Bei der Akkumulation der Wirbelströme zur Berechnung der Wirbelstrominformation handelt es sich insbesondere um eine zeitliche Akkumulation. Vorzugsweise wird allein unter Verwendung von Abklingkonstanten bzw. Zeitkonstanten berechnet, wie stark die Wirbelströme sind, unabhängig vom örtlichen Verlauf. Am Ende werden die Wirbelströme durch das Ausspielen des Wirbelstromkompensationsgradientenpulses, der wiederum Wirbelströme erzeugt, kompensiert. Dieser Wirbelstromkompensationsgradientenpuls erzeugt vorteilhafterweise Wirbelströme der umgekehrten Polarität, um die genannten aufakkumulierten Wirbelströme zu kompensieren. Dadurch, dass dieser Wirbelstromkompensationsgradientenpuls üblicherweise die gleiche räumliche Verteilung von Wirbelströmen erzeugt wie die ursprünglichen Gradienten der Sequenz, ist eine Berechnung der räumlichen Verteilung vorteilhafterweise nicht nötig.

In S13 wird anhand der in S12 berechneten Wirbelstrominformation zumindest ein Wirbelstromkompensationsgradient zur Kompensation der Wirbelströme berechnet.

Insbesondere wenn das nächste auszuspielende Event bzw. Sequenzmodul der Magnetresonanzsequenzdaten ein Fettsättigungspuls ist (was beispielsweise anhand der Frequenz des Fettsättigungspulses recht einfach zu erkennen ist), wird automatisch ein Wirbelstromkompensationsgradientenpuls berechnet, wobei vorzugsweise alle in der Messung bislang auf den einzelnen Achsen durchlaufenen Gradiententrajektorien berücksichtigt werden. Für den Algorithmus ist es dabei irrelevant in welcher Repetition oder nach welchem DWI-Block er sich befindet, da all diese Magnetfeldgradienten vorher in der Berechnung erfasst worden waren.

Der Wirbelstromkompensationsgradientenpuls wird dabei vorteilhafterweise so ausgelegt, dass die durch ihn erzeugten Kompensationswirbelströme die bereits vorhandenen wirbelstrom-induzierten Feldstörungen ganz oder teilweise kompensieren. Insbesondere kann auch beispielsweise applikations-abhängig spezifiziert werden, bis zu welchem Teil (z.B. 50% oder bis zu einer gewissen definierten tolerierbaren Feldstörung) die vorhandenen Feldstörungen kompensiert werden. Das kann insbesondere die notwendige Dauer und/oder die benötigte Amplitude des Wirbelstromkompensationsgradientenpulses reduzieren.

In S14 werden modifizierter Magnetresonanzsequenzdaten erzeugt, indem der Wirbelstromkompensationsgradientenpuls in die ursprünglichen Magnetresonanzsequenzdaten eingefügt wird. Es wird also im Vergleich zum ursprünglichen Gradientenverlauf der Sequenz gezielt eingegriffen und adaptiert, um eine Wirbelstromkompensation zu erreichen.

Vorzugsweise wird dabei ein Zeitabschnitt in den ursprünglichen Magnetresonanzsequenzdaten identifiziert, in dem durch die Magnetresonanzvorrichtung keine Sequenzmodule appliziert werden, insbesondere keine Gradientenpulse geschaltet oder HF-Pulse gesendet werden. Der Wirbelstromkompensationsgradientenpuls wird dann in den identifizierten Zeitabschnitt in die ursprünglichen Magnetresonanzsequenzdaten eingefügt.

Vorteilhafterweise wird der Wirbelstromkompensationsgradientenpuls in eine "Pause" der Sequenz eingefügt, sodass das Timing der Sequenz nicht verändert werden muss. In dieser "Pause" werden vorzugsweise keine anderen Sequenzmodule als der Wirbelstromkompensationsgradientenpuls ausgespielt. Dies soll anhand eines in Fig. 3 dargestellten Beispiels verdeutlicht werden.

Dort ist eine zeitliche Abfolge eines Abschnitts einer Magnetresonanzsequenz, genauer: einer echoplanaren (EPI) DWI-Sequenz, dargestellt. Die ursprünglichen Magnetresonanzdaten umfassen dabei einen HF-Anregungspuls RFe, einen ersten Diffusionsgradientenpuls Gd1, einen HF-Refokussierungspuls RFr und einen zweiten Diffusionsgradientenpuls Gd2, woran sich mehrere Sequenzmodule einer EPI-Auslesung EPIro anschließen, sowie eines HF-Fettsättigungspuls RFfs, bevor schließlich wieder ein HF-Anregungspuls RFe folgt. In S14 wird erkannt, dass zwischen dem Ende der EPI-Auslesung EPIro und dem Fettsättigungspuls RFfs keine Sequenzmodule appliziert werden. Ferner kann auch erkannt werden, dass es sich bei dem Sequenzmodul RFfs um einen Fettsättigungspuls handelt. In diesem "leeren" Zeitabschnitt vor dem Fettsättigungspuls RFfs wird nun der in S13 berechnete Wirbelstromkompensationsgradient Gecc eingefügt, so dass daraus dann die modifizierten Magnetresonanzsequenzdaten resultieren.

Optional wird vorgeschlagen, dass die vorbestimmte Magnetresonanzsequenz dedizierte Platzhalter für die Wirbelstromkompensationsgradientenpulse vorhalten kann, an deren Stelle der Wirbelstromkompensationsgradienten eingefügt werden kann. Diese Platzhalter können beispielsweise durch ein Flag als solche gekennzeichnet werden, womit direkt auch die vorteilhafte Stelle vorgegeben wäre und eine vorab beschriebene Identifizierung geeigneter Zeitabschnitte entfallen könnte.

In S15 werden die modifizierten Magnetresonanzsequenzdaten an das Gradientenerzeugungssystem, insbesondere an die Gradientensteuereinheit 19, der Magnetresonanzvorrichtung 10 ausgegeben. Die Gradientensteuereinheit 19 steuert wiederum die Hochfrequenzantenneneinheit 20 und gibt in S20 gemäß den modifizierten Magnetresonanzsequenzdaten den Wirbelstromkompensationsgradienten Gecc aus.

Die in Fig. 2 dargestellte Anpassung der vorbestimmten Magnetresonanzsequenz erfolgt vorteilhafterweise zumindest teilweise in Echtzeit und/oder on-the-fly während der Magnetresonanzmessung, was durch den Pfeil zwischen S20 und S11 angedeutet ist. Es werden also fortlaufend immer wieder aktuelle ursprüngliche Magnetresonanzsequenzdaten der vorbestimmten Magnetresonanzsequenz der Kompensationsberechnungseinheit 26 zur Verfügung gestellt, welche dann in S10 modifiziert werden. Diese Modifikation erfolgt vorteilhafterweise automatisiert und unabhängig von dem Sequenztyp der vorbestimmten Magnetresonanzsequenz.

Ein grundlegender Vorteil des vorgeschlagenen Verfahrens ist seine Unabhängigkeit von der spezifischen Sequenz bzw. dem Sequenztyp. Vorteilhafterweise wird das Verfahren nur einmalig zentral implementiert und gepflegt, während in den Sequenzen keine oder nur minimale Änderungen benötigt werden.

Es wird abschließend noch einmal darauf hingewiesen, dass es sich bei den vorhergehend detailliert beschriebenen Verfahren sowie bei der dargestellten Kompensationsberechnungseinheit und Magnetresonanzvorrichtung lediglich um Ausführungsbeispiele handelt, welche vom Fachmann in verschiedenster Weise modifiziert werden können, ohne den Bereich der Erfindung zu verlassen. Weiterhin schließt die Verwendung der unbestimmten Artikel "ein" bzw. "eine" nicht aus, dass die betreffenden Merkmale auch mehrfach vorhanden sein können. Ebenso schließt der Begriff "Einheit" nicht aus, dass die betreffenden Komponenten aus mehreren zusammenwirkenden Teil-Komponenten bestehen, die gegebenenfalls auch räumlich verteilt sein können.

**Patentansprüche**

1.    Verfahren zur automatischen Kompensation von Wirbelströmen in einer Magnetresonanzvorrichtung, umfassend:

   • Ermitteln modifizierter Magnetresonanzsequenzdaten durch eine Kompensationsberechnungseinheit als Zwischenschicht der Magnetresonanzvorrichtung,
   • Durchführen einer Magnetresonanzmessung, bei der in der Magnetresonanzvorrichtung Magnetfeldgradienten anhand der modifizierten Magnetresonanzsequenzdaten durch ein Gradientenerzeugungssystem erzeugt werden,

wobei das Ermitteln der modifizierten Magnetresonanzsequenzdaten umfasst:

   • Empfangen ursprünglicher Magnetresonanzsequenzdaten einer vorbestimmten Magnetresonanzsequenz,
   • Berechnen einer Wirbelstrominformation über Wirbelströme, die durch Anwenden der ursprünglichen Magnetresonanzsequenzdaten in der Magnetresonanzvorrichtung hervorgerufen werden würden,
   • Berechnen zumindest eines Wirbelstromkompensationsgradientenpulses zur Kompensation der Wirbelströme anhand der berechneten Wirbelstrominformation,
   • Erzeugen modifizierter Magnetresonanzsequenzdaten durch Einfügen des zumindest einen Wirbelstromkompensationsgradientenpulses in die ursprünglichen Magnetresonanzsequenzdaten,
   • Ausgeben der modifizierten Magnetresonanzsequenzdaten an das Gradientenerzeugungssystem der Magnetresonanzvorrichtung.

**2.** Verfahren nach Anspruch 1,
wobei das Ermitteln der modifizierten Magnetresonanzsequenzdaten zumindest teilweise während der Magnetresonanzmessung erfolgt.

**3.** Verfahren nach einem der vorangehenden Ansprüche,
wobei das Ermitteln der modifizierten Magnetresonanzsequenzdaten in Echtzeit und/oder on-the-fly erfolgt.

**4.** Verfahren nach einem der vorangehenden Ansprüche,
wobei die ursprünglichen Magnetresonanzsequenzdaten der vorbestimmten Magnetresonanzsequenz aus einer Systemsteuereinheit der Magnetresonanzvorrichtung bereitgestellt werden, wobei die ursprünglichen Magnetresonanzsequenzdaten der vorbestimmten Magnetresonanzsequenz in der Systemsteuereinheit unverändert bleiben.

**5.** Verfahren nach einem der vorangehenden Ansprüche,
wobei die vorbestimmte Magnetresonanzsequenz eine diffusionsgewichtete Sequenz umfasst.

**6.** Verfahren nach einem der vorangehenden Ansprüche,
wobei das Berechnen der Wirbelströme anhand zumindest eines Parameters erfolgt, der spezifisch für einen Typ der Magnetresonanzvorrichtung ist.

**7.** Verfahren nach einem der vorangehenden Ansprüche,

wobei das Ermitteln der modifizierten Magnetresonanzsequenzdaten ein Erkennen zumindest eines Fettsättigungspulses in den ursprünglichen Magnetresonanzsequenzdaten umfasst, wobei vor zumindest einen Fettsättigungspuls ein Wirbelstromkompensationsgradient in die ursprünglichen Magnetresonanzsequenzdaten eingefügt wird.

**8.** Verfahren nach einem der vorangehenden Ansprüche,

wobei die vorbestimmte Magnetresonanzsequenz ein Anwenden von Gradientenpulsen auf mehreren Achsen des Gradientenerzeugungssystems der Magnetresonanzvorrichtung vorsieht,
wobei bei dem Berechnen zumindest eines Wirbelstromkompensationsgradientenpulses mehrere, insbesondere alle, bisher in der Magnetresonanzmessung angewandten Gradientenpulse auf den mehreren Achsen des Gradientenerzeugungssystems der Magnetresonanzvorrichtung berücksichtigt werden.

**9.** Verfahren nach einem der vorangehenden Ansprüche,

wobei das Ermitteln der modifizierten Magnetresonanzsequenzdaten ein Abschätzen einer Magnetfeldstörung umfasst, welche durch die Wirbelströme bei Anwenden der ursprünglichen Magnetresonanzsequenzdaten in der Magnetresonanzvorrichtung hervorgerufen werden würde,
wobei nur dann ein Wirbelstromkompensationsgradientenpuls berechnet und in die ursprünglichen Magnetresonanzsequenzdaten eingefügt wird, wenn die Magnetfeldstörung einen vorgegebenen Schwellwert überschreitet.

**10.** Verfahren nach einem der vorangehenden Ansprüche,

wobei das Ermitteln der modifizierten Magnetresonanzsequenzdaten eine Identifizierung eines Zeitabschnitts in den ursprünglichen Magnetresonanzsequenzdaten umfasst, in dem durch die Magnetresonanzvorrichtung keine Gradientenpulse geschaltet oder HF-Pulse gesendet werden,
wobei der zumindest eine Wirbelstromkompensationsgradientenpuls in den identifizierten Zeitabschnitt in die ursprünglichen Magnetresonanzsequenzdaten eingefügt wird.

**11.** Verfahren nach einem der vorangehenden Ansprüche,
wobei die ursprünglichen Magnetresonanzsequenzdaten zumindest einen dedizierte Platzhalter zum Einfügen berechneter Wirbelstromkompensationsgradientenpulse aufweist.

**12.** Kompensationsberechnungseinheit zum Ermitteln von modifizierten Magnetresonanzsequenzdaten zum Durchführen einer Magnetresonanzmessung mit einer Magnetresonanzvorrichtung, wobei die Kompensationsberechnungseinheit ausgebildet ist zum:

• Empfangen ursprünglicher Magnetresonanzsequenzdaten einer vorbestimmten Magnetresonanzsequenz,
• Berechnen einer Wirbelstrominformation über Wirbelströme, die durch Anwenden der ursprünglichen Magnetresonanzsequenzdaten in der Magnetresonanzvorrichtung hervorgerufen werden würden,
• Berechnen zumindest eines Wirbelstromkompensationsgradientenpulses zur Kompensation der Wirbelströme anhand der berechneten Wirbelstrominformation,

• Erzeugen modifizierter Magnetresonanzsequenzdaten durch Einfügen des zumindest einen Wirbelstromkompensationsgradientenpulses in die ursprünglichen Magnetresonanzsequenzdaten,

• Ausgeben der modifizierten Magnetresonanzsequenzdaten an ein Gradientenerzeugungssystem einer Magnetresonanzvorrichtung zum Durchführen einer Magnetresonanzmessung.

13. Magnetresonanzvorrichtung mit einer Kompensationsberechnungseinheit als Zwischenschicht nach Anspruch 12, wobei die Magnetresonanzvorrichtung ausgebildet ist, ein Verfahren nach einem der Ansprüche 1 bis 11 durchzuführen.

14. Computerprogrammprodukt, welches ein Programm umfasst und direkt in einen Speicher einer programmierbaren Kompensationsberechnungseinheit einer Magnetresonanzvorrichtung ladbar ist, mit Programmmitteln, um ein Verfahren nach einem der Ansprüche 1 bis 11 auszuführen, wenn das Programm in der Kompensationsberechnungseinheit der Magnetresonanzvorrichtung ausgeführt wird.

FIG 1

## FIG 2

## FIG 3

Europäisches Patentamt

European Patent Office

Office européen des brevets

## EUROPÄISCHER RECHERCHENBERICHT

**Nummer der Anmeldung**

**EP 21 21 3584**

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2010/148774 A1 (KAMATA MITSUKAZU [JP]) 17. Juni 2010 (2010-06-17) * Absatz [0035] - Absatz [0148] * * Abbildungen 1,2,3,4,8,12,13,14 * ----- | 1-8, 10-14 | INV. G01R33/565 |
| X | DE 10 2019 215046 A1 (SIEMENS HEALTHCARE GMBH [DE]) 1. April 2021 (2021-04-01) * Abbildungen 3,4,5,6 * * Absatz [0024] - Absatz [0080] * ----- | 1-9, 11-14 | |
| X | DE 693 29 873 T2 (KONINKL PHILIPS ELECTRONICS NV [NL]) 13. September 2001 (2001-09-13) * Abbildungen 1,4,5 * * Absatz [0013] - Absatz [0038] * ----- | 1,4,6,8, 10-14 | |

**RECHERCHIERTE SACHGEBIETE (IPC)**

G01R

Der vorliegende Recherchenbericht wurde für alle Patentansprüche erstellt

| Recherchenort | Abschlußdatum der Recherche | Prüfer |
|---|---|---|
| München | 29. April 2022 | Durst, Markus |

EPO FORM 1503 03.82 (P04C03)

EP 4 194 878 A1

**ANHANG ZUM EUROPÄISCHEN RECHERCHENBERICHT
ÜBER DIE EUROPÄISCHE PATENTANMELDUNG NR.**

EP 21 21 3584

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

29-04-2022

| Im Recherchenbericht angeführtes Patentdokument | Datum der Veröffentlichung | Mitglied(er) der Patentfamilie | Datum der Veröffentlichung |
|---|---|---|---|
| US 2010148774 A1 | 17-06-2010 | JP 5416960 B2 | 12-02-2014 |
| | | JP 2010142354 A | 01-07-2010 |
| | | US 2010148774 A1 | 17-06-2010 |
| DE 102019215046 A1 | 01-04-2021 | DE 102019215046 A1 | 01-04-2021 |
| | | US 2021096205 A1 | 01-04-2021 |
| DE 69329873 T2 | 13-09-2001 | DE 69329873 T2 | 13-09-2001 |
| | | JP 3504301 B2 | 08-03-2004 |
| | | JP H06261877 A | 20-09-1994 |
| | | US 5455512 A | 03-10-1995 |

Für nähere Einzelheiten zu diesem Anhang : siehe Amtsblatt des Europäischen Patentamts, Nr.12/82